# EUROPÄISCHE PATENTSCHRIFT

(11) **EP 4 131 382 B1**
(45) Veröffentlichungstag und Bekanntmachung des Hinweises auf die Patenterteilung: **26.02.2025**
(21) Anmeldenummer: 21189012.4
(22) Anmeldetag: 02.08.2021
(51) Int. Cl.: H01L 27/148

(54) **LADUNGSÜBERTRAGUNGSVORRICHTUNG MIT EINEM MÜNDUNGSBEREICH FÜR TAKTFREQUENZEN AB 100 MHZ**
CHARGE TRANSFER DEVICE WITH AN OPENING AREA FOR CLOCK FREQUENCIES ABOVE 100 MHZ
DISPOSITIF DE TRANSFERT DE CHARGE DOTÉ D'UNE ZONE D'OUVERTURE POUR FRÉQUENCES D'HORLOGE À PARTIR DE 100 MHZ

(43) Veröffentlichungstag der Anmeldung: 08.02.2023
(73) Patentinhaber: Espros Photonics AG, 7320 Sargans (CH)
(72) Erfinder: DE COI, Beat, 7304 Maienfeld (CH); YU, Chongqi, 7310 Bad Ragaz (CH)
(74) Vertreter: Otten, Roth, Dobler & Partner mbB Patentanwälte

(56) Entgegenhaltungen:
- GB-A- 2 551 108
- US-A1- 2004 259 293
- US-A1- 2009 075 419

## Beschreibung

Die Erfindung betrifft eine Halbleiterstruktur mit einem Ladungsübertragungskanal für Taktfrequenzen im Bereich ab 100 MHz, vorzugsweise ab 250 MHz, besonders bevorzugt bis 400 MHz.

Bei Taktfrequenzen über 100 MHz, speziell über 250 MHz und insbesondere bis 400 MHz können vermehrt Verluste beim Transport der Ladungsträger durch einen Ladungsübertragungskanal auftreten.

US 2009/075419 A1 offenbart eine Ladungsübertragungsvorrichtung in Form einer CCD mit zwei Ladungsübertragungskanälen sowie einem Mündungsbereich des einen Ladungsübertragungskanals in den anderen.

Es ist Aufgabe der Erfindung, eine verbesserte Ladungsübertragung bei Taktfrequenzen über 100 MHz, vorzugsweise ab 250 MHz, besonders bevorzugt bis 400 MHz bereitzustellen.

Die Aufgabe wird durch die Merkmale des Anspruchs 1 gelöst. Durch die in den Unteransprüchen genannten Maßnahmen sind vorteilhafte Ausführungen und Weiterbildungen der Erfindung möglich.

Die erfindungsgemäße Ladungsübertragungsvorrichtung verwendet unter anderem einen Ladungsträgerkanal. Ein Ladungsübertragungskanal kann eine Überlappung der möglichen elektrostatischen Wirkung von aneinander angrenzenden Gattern mit einer Leitungsschicht in einem Halbleiter sein. Der Ladungsübertragungskanal kann so das Schnittvolumen aus der Projektion der elektrostatischen Wirkung der Gatter auf die Volumenstruktur der Leitungsschicht sein.

Die Leitungsschicht, in welcher der Ladungsträgertransport bzw. die Ladungsträgerübertragung stattfindet, kann in einem Halbleitersubstrat liegen und unterschiedlich zum umgebenden Halbleitersubstrat dotiert sein, sodass sich Ladungsträger in der Leitungsschicht bewegen können und nicht in das umgebende Halbleitersubstrat austreten. Eine Leitungsschicht kann vergraben sein oder an der Oberfläche des Halbleitersubstrats liegen.

Die Gatter können Elektroden sein, welche entlang der Leitungsschicht angeordnet und durch eine dünne, nichtleitende Trennschicht von der Leitungsschicht getrennt sind, sodass sich eine Potentialänderung der Gatter als Änderung des elektrischen Feldes im überlappend zugeordneten Bereich der Leitungsschicht auswirkt. Die Gatter können durch eine dünne Trennschicht isoliert auf dem Halbleitersubstrat liegen.

Ladungsträger können Elektronen oder Löcher sein.

Durch entsprechende Potentialänderungen angrenzender Gatter können Ladungsträger im Ladungsübertragungskanal transportiert werden, sodass der Ladungsübertragungskanal als Leitungskanal für einen gerichteten Fluss von Ladungsträger wirken kann. Die Potentialänderung folgt im Allgemeinen einer Taktfrequenz. Die Potentialänderungen können dabei einer Taktfrequenz folgen. Die Taktfrequenz bestimmt die Geschwindigkeit des Ladungstransports und damit die zeitliche Auflösung und Leistungsfähigkeit umgebender oder angeschlossener Systeme wie etwa Sensoren oder Recheneinheiten.

Grenzen, Form und Verlauf der Gatter, der Leitungsschicht und des Ladungsübertragungskanals sind stets in Draufsicht von den Gattern her in Richtung der Leitungsschicht angegeben, soweit im Einzelfall nicht anders genannt ist. Der Verlauf des Ladungsübertragungskanals und räumliche Relationen sind stets in Richtung des Ladungsträgerflusses im Ladungsübertragungskanal angegeben, soweit im Einzelfall nicht anders genannt ist.

Falls die Breite des Verlaufs der aneinandergereihten Gatter schmaler ist als die Breite des Verlaufs der zugeordneten Leitungsschicht, dann sind die Grenzen der Breite des Verlaufs des Ladungsübertragungskanals durch die Grenzen des Verlaufs der Breite der aneinandergereihten Gatter gegeben. Falls die Breite des Verlaufs der aneinandergereihten Gatter breiter ist als die Breite des Verlaufs der zugeordneten Leitungsschicht, dann sind die Grenzen der Breite des Verlaufs des Ladungsübertragungskanals durch die Grenzen des Verlaufs der Breite der zugeordneten Leitungsschicht gegeben.

Im Zusammenhang mit der Erfindung wurde erkannt, dass bei höheren Taktfrequenzen ab 150 MHz oder 250 MHz oftmals ein Teil der unter einem Gatter befindlichen Ladungsträger bei entsprechender Potentialänderung nicht wie gewünscht zum nächsten Gatter übertritt; in vorteilhafter Weise kann dieser Effekt durch die erfindungsgemäße Ladungsübertragungsvorrichtung reduziert bzw. vermieden werden.

Die erfindungsgemäße Ladungsübertragungsvorrichtung ist eine Ladungsübertragungsvorrichtung ensprechend Anspruch 1.

Dieser erfindungsgemäße Ladungsübertragungskanal kann den Vorteil ausbilden, dass Ladungsträger mit weniger Widerstand und/oder weniger Verlusten fliessen können.

Die Länge des Mündungsbereichs entlang des Leitungskanals ist kleiner als die Länge des Bereichs der zugeordneten zwei benachbarten Gatter entlang des Ladungsübertragungskanals und entspricht, 45-75%, 55-65%, oder 60% der Länge des Bereichs der zugeordneten zwei benachbarten Gatter entlang des Ladungsübertragungskanals, um eine möglichst verlustfreie Übergabe der Ladungsträger von Gatter zu Gatter zu ermöglichen.

Ferner sind für die Verringerung der Verluste auch folgende Maßnahmen getroffen: Der Mündungsbereich grenzt mit seiner Länge entlang des Leitungsübertragungskanals über eine grössere Länge an den Bereich des entgegen der Flussrichtung liegenden zugeordneten Gates versetzt an als an den Bereich des in Flussrichtung liegenden zugeordneten Gates, wobei die Gates mit Abständen elektrisch getrennt angeordnet sind, und grenzt insbesondere mehr als 50%, mehr als 60%, zwischen 60% und 75%, oder zu 2/3 an den Bereich des entgegen der Flussrichtung liegenden zugeordneten Gates an.

Vorzugsweise weist der Mündungsbereich eine Ausbuchtung auf in welcher der Querschnitt zur Flussrichtung zuerst zunimmt (insbesondere um mehr als 20%, 40%, 80% oder 100%) und dann wieder abnimmt (insbesondere um mehr als 20%, 40%, oder 80%), welche sich in ihrer Länge in Flussrichtung mindestens, im Wesentlichen oder genau über den Mündungsbereich erstreckt, wobei die Länge der Ausbuchtung in Flussrichtung kleiner ist als die Breite der Zunahme des Querschnitts, insbesondere kleiner 50%, kleiner 25%, oder kleiner 12%, und wobei die Ausbuchtung insbesondere im Wesentlichen rechteckig ist.

Vorzugsweise weist der Ladungsübertragungskanal einen Bereich einer Verengung auf in welchem der Querschnitt in Flussrichtung abnimmt und welcher entgegen der Flussrichtung vor der Mündungsstelle und mindestens teilweise im Bereich des einen entgegen der Flussrichtung liegenden zugeordneten Gates angeordnet ist und insbesondere abgeschrägt und/oder trichterförmig ausgeführt ist um insbesondere den Rücklauf (Spill Back) oder der Flusswiderstand oder der Verlust der Ladungsträger in Flussrichtung zu reduzieren.

Vorzugsweise ist das Halbleitersubstrat p+ dotiert und/oder die Leitungsschicht schwach n- dotiert und/oder sind die Gatter aus Metall gebildet und/oder ist zwischen den Gattern und der Leitungsschicht eine nichtleitende Schicht angeordnet.

### Überblick über die Zeichnungen:

Ausführungsbeispiele der Erfindung sind in den Zeichnungen dargestellt und werden im Folgenden näher erläutert. Gleiche Bezugszeichen in den einzelnen Figuren bezeichnen dabei einander entsprechende Elemente. Es zeigen:
Fig. 1 Leitungsübertragungskanal entsprechend eines Beispiels das zum Verständnis der Erfindung beiträgt in Schnitt entlang Flussrichtung
Fig. 2 Leitungsübertragungskanal entsprechend eines Beispiels das zum Verständnis der Erfindung beiträgt im Schnitt senkrecht Flussrichtung
Fig. 3 Leitungsübertragungskanal entsprechend eines Beispiels das zum Verständnis der Erfindung beiträgt mit Verengung in Draufsicht
Fig. 4 Leitungsübertragungskanal entsprechend eines Ausführungsbeispiel der beanspruchten Erfindung mit Ausbuchtung in Draufsicht
Fig. 5 Leitungsübertragungskanal entsprechend eines Ausführungsbeispiel der beanspruchten Erfindung mit Einmündung in Draufsicht

### Detaillierte Beschreibung der Zeichnungen:

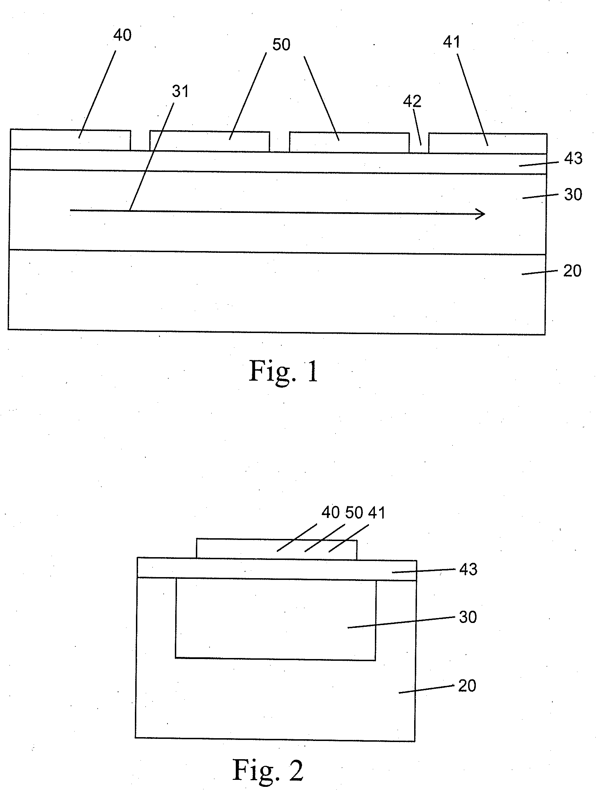

Fig. 1 zeigt einen Ladungsübertragungskanal 10 in Seitenansicht entlang der Flussrichtung 31 der Ladungsträger der folgenden Figuren. Der Aufbau ist analog CCD Technologie. Das umgebende Halbleitersubstrat 20 ist p+ dotiert. Im Halbleitersubstrat 20 ist eine vergrabene Leitungsschicht 30 angeordnet. Die Leitungsschicht ist schwach n- dotiert. Dies hat zur Folge, dass in der Leitungsschicht Elektronen als Ladungsträger frei beweglich sind und nicht in das Halbleitersubstrat eindringen. Auf der Leitungsschicht ist eine Isolationsschicht 43 aufgebracht und darauf sind Gatter 40, 41, 50 aus Metall angeordnet. Die Gatter sind durch Zwischenräume elektrisch voneinander getrennt. Der nicht dargestellte Taktgeber beaufschlagt die benachbarten Gatter wechselweise mit einem positiven Potential in einer Taktfrequenz von 250 MHz, sodass Leitungselektronen in der Leitungsschicht von einem Gatter zum nächsten angezogen und so in Flussrichtung verschoben werden. Die Taktfrequenz könnte auch lediglich über 100 MHz, über 150 MHz oder über 200 MHz betragen. Im Allgemeinen ist die Taktfrequenz nicht höher als 300 MHz. Die Leitungselektronen können beispielsweise photoinduzierte Elektronen aus einem an den Leitungskanal angeschlossenen Bildsensor sein.

Das Halbleitersubstrat 20 ist p+ dotiert und die Leitungsschicht 30 ist n- dotiert. Die Isolationsschicht 43 ist aus SiO2 und die Gatter sind aus Metall gebildet.

Fig. 2 zeigt den Ladungsübertragungskanal in Seitenansicht senkrecht zur Flussrichtung der Ladungsträger der folgenden Figuren. Die Leitungsschicht 30 ist vergraben, sodass im sie von oben und der Seite vom Halbleitersubstrat 20 umfasst ist. Halbleitersubstrat 20 und Leitungsschicht 30 sind nach oben mit einer Isolationsschicht versehen. Die Gatter 40, 41, 50 sind im Bereich über der Leitungsschicht 30 auf der Isolationsschicht 43 angeordnet. Die Gatter sind entlang der Flussrichtung in der Breitenausdehnung schmäler als die Leitungsschicht ausgefiihrt.

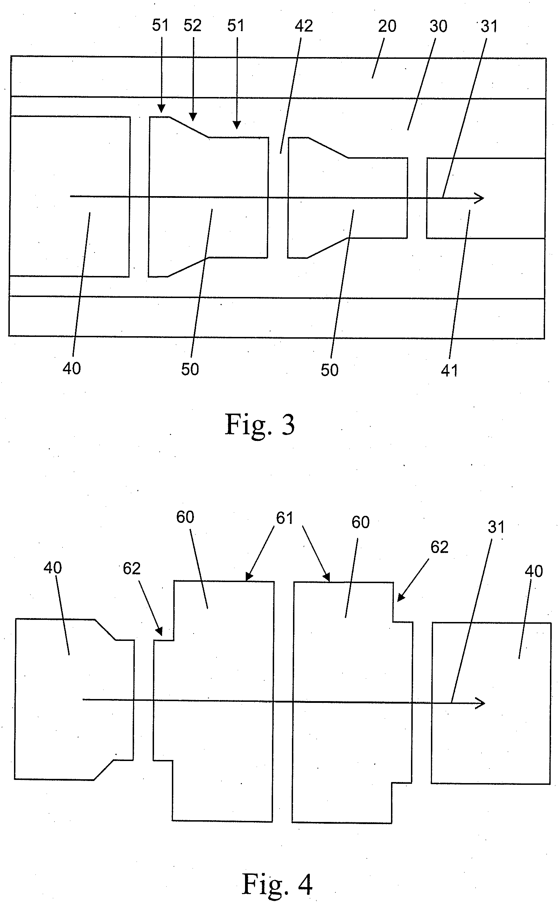

Fig. 3 zeigt einen Ladungsübertragungskanal in Draufsicht. Im Halbleitersubstrat 20 ist die Leitungsschicht 30 eingebettet. Die darüber liegende Isolationsschicht ist nicht gezeigt. Über dem Bereich der Leitungsschicht 30, durch die nicht gezeigte Isolationsschicht getrennt, sind die Gatter 40, 50, 41 in Flussrichtung 31 der Elektronen und mit Abständen 42 elektrisch getrennt angeordnet. Insgesamt zeigen die Gatter in Flussrichtung eine Verengung des Querschnitts. Das erste Gatter 40 weist deinen breiten Querschnitt auf, während das letzte Gatter 41 einen vergleichsweise schmäleren Querschnitt aufweist. Die beiden Gatter 50 weisen einen sich in Flussrichtung 31 verengenden Querschnitt auf. Das sich verengende Gatter 50 weist in Flussrichtung 31 zunächst einen breiten Bereich mit konstantem Querschnitt ohne Verengung 51 auf, dann einen im Querschnitt schmäler werdenden Bereich mit Verengung 52 und darauf einen schmäleren Bereich mit wieder konstantem Querschnitt ohne Verengung 51. Das Gatter 50 weist dabei Bereiche mit konstantem Querschnitt am Übergang zu den benachbarten Gattern auf. Der entgegen der Flussrichtung angeordnete Bereich mit konstantem Querschnitt ohne Verengung ist kürzer als der in Flussrichtung angeordnete Bereich mit konstantem Querschnitt ohne Verengung. Dadurch ist der schmäler werdende Bereich mit Verengung 52 aus der Mitte des Gatters 50 entgegen der Richtung der Flussrichtung verschoben angeordnet. Der schmäler werdende Bereich mit Verengung 52 ist beidseitig abgeschrägt ausgeführt, sodass er eine trichterförmige Form aufweist. Durch die so gezeigte Ausführung einer Verengung kann der Rücklauf (Spill Back) und/oder der Flusswiderstand und/oder die Verluste der Ladungsträger in Flussrichtung minimiert werden.

Fig. 4 zeigt die Gatter eines Ladungsübertragungskanals in Draufsicht. Die unter den Gattern befindliche Leitungsschicht ist nicht dargestellt. Die maximale Breite der in Flussrichtung zu Beginn und am Ende der gezeigten Gatterabfolge liegenden Gatter 40 bildet die typische Breite des Querschnitts des Leitungsübertragungskanals. Demgegenüber weisen die zwei Gatter 60 einen zusammenhängenden Bereich einer Ausbuchtung 61 auf bei welchem der Querschnitt im Vergleich zur typischen Breite um die Breite 62 etwa 25 % vergrössert ist. Unmittelbar der Ausbuchtung weist das erste Gatter 60 mit der Ausbuchtung eine Verengung 62 auf, bei welcher der Querschnitt des Ladungsübertragungskanals im Vergleich zur typischen Breite schmäler ist.

Dadurch ist der Eintritt in die Ausbuchtung schmaler als der Austritt aus der Ausbuchtung. Die Verengung 62 ist bereits beim in Flussrichtung vorhergehenden Gatter 40 ausgeführt, welches durch einen richterförmigen Bereich den Querschnitt vom typischen Querschnitt auf den reduzierten Querschnitt der Verengung verringert. Durch die - so gezeigte Ausführung einer Ausbuchtung kann der Rücklauf (Spill Back) und/oder der Flusswiderstand und/oder die Verluste der Ladungsträger in Flussrichtung minimiert werden.

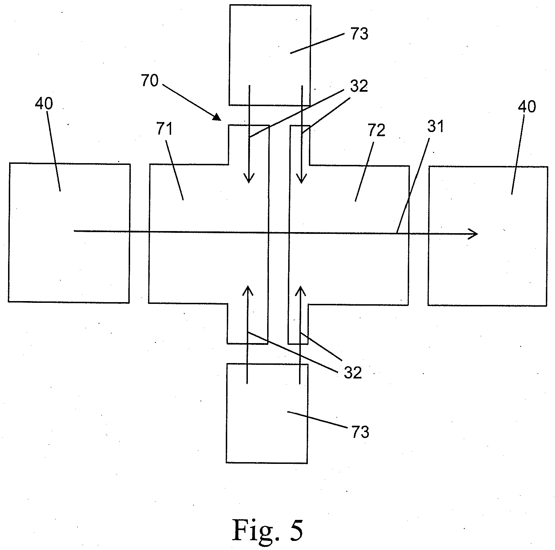

Fig. 5 zeigt die Anordnung der Gatter eines Leitungsübertragungskanals mit einem rechten und einem linken seitlichen Mündungsbereich 70 in Draufsicht. Ein erster Ladungsübertragungskanal ist in Flussrichtung 31 der Ladungsträger durch die Abfolge der Gatter 40, 71, 72 und 40 gebildet. Die unter den Gattern befindliche Leitungsschicht ist nicht dargestellt. Die Gatter 71 und 72 weisen Ausbuchtungen senkrecht zur Flussrichtung in Richtung der Gatter 73 auf bei der der erste Ladungsübertragungskanal einen erhöhten Querschnitt in Bezug auf die vorherigen und nachfolgenden Gatter 40 aufweist. Ein zweiter Ladungsübertragungskanal ist in Flussrichtung 32 der Ladungsträger durch die Abfolge der Gatter 73 auf 71 und 72 jeweils rechts und links vom ersten Ladungsübertragungskanal gebildet. Die . Ladungsträger der zweiten Ladungsträgerkanäle fliessen vom Gatter 73 teilweise in das Gatter 71 und teilweise in das Gatter 72 um sich dann zusammen mit den Ladungsträgern des ersten Ladungsträgerübertragungskanals in dessen Flussrichtung 31 weiter zu bewegen. Der Mündungsbereich 70 ist durch den Übergang zwischen dem ersten Gatter 73 des zweiten Ladungsübertragungskanals ausserhalb des ersten Ladungsübertragungskanals und den beiden angrenzenden Gattern 71 und 72 des ersten Ladungsübertragungskanals gebildet. Der Querschnitt des Mündungsbereichs 70 entspricht etwa 60% der Länge der beiden angrenzenden Gatter 71 und 72 in Flussrichtung. Insgesamt überlappt der Mündungsbereich mit dem entgegen der Flussrichtung 31 liegenden angrenzenden Gatter 71 des ersten Ladungsübertragungskanals zu 2/3 und mit dem in Flussrichtung 31 liegenden angrenzenden Gatter 72 des ersten Ladungsübertragungskanals zu 1/3. Somit ist der Mündungsbereich in Bezug auf die beiden angrenzenden Gatter des ersten Ladungsübertragungskanals entgegen der Flussrichtung 31 verschoben. Durch die so gezeigte Ausführung eines Mündungsbereichs kann der Rücklauf (Spill Back) und/oder der Flusswiderstand und/oder die Verluste der Ladungsträger in Flussrichtung minimiert werden.

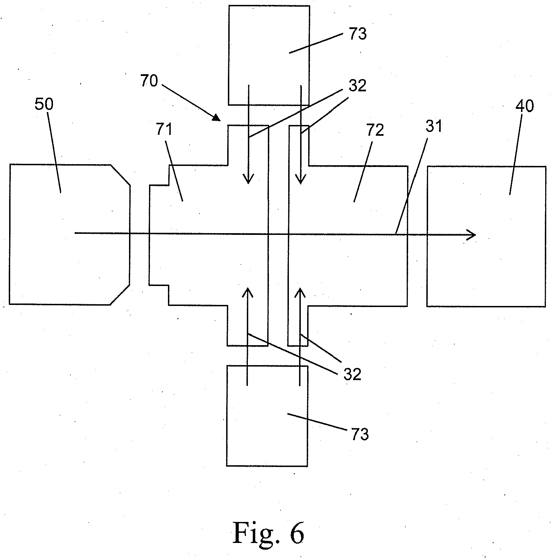

Fig. 6 zeigt die Anordnung von Figur 5, wobei das erste Gatter 50 eine Verengung aufweist. Durch die so gezeigte Ausführung eines Mündungsbereichs kann der Rücklauf (Spill Back) und/oder der Flusswiderstand und/oder die Verluste der Ladungsträger in Flussrichtung weiter minimiert werden.

### Bezugszeichenliste:

- 10: Ladungsübertragungskanal

- 20: Halbleitersubstrat

- 30: Leitungsschicht
- 31: Flussrichtung
- 32: Flussrichtung

- 40: Gatter, breit
- 41: Gatter, schmal
- 42: Isolierender Abstand zwischen den Gattern
- 43: Isolationsschicht

- 50: Gatter mit Verengung
- 51: Bereich ohne Verengung
- 52: Bereich mit Verengung

- 60: Gatter mit Ausbuchtung
- 61: Bereich mit Ausbuchtung
- 62: Breite der Ausbuchtung
- 62: Verengung

- 70: Mündungsbereich
- 71: Erstes Gatter des ersten Leitungskanals mit Mündungsbereich
- 72: Zweites Gatter des ersten Leitungskanals mit Mündungsbereich
- 73: Gatter eines weiteren Leitungskanals

## Patentansprüche

1. Ladungsübertragungsvorrichtung
- mit einem Ladungsübertragungskanal in einem Halbleitersubstrat
- mit einer dotierten Leitungsschicht
- zur beweglichen Aufnahme der Ladungsträger
- mit einer Abfolge von mindestens zwei elektrisch getrennten Gattern
- welche benachbart aufeinander folgen
- zur Verschiebung der Ladungsträger in der Leitungsschicht
- in eine Flussrichtung
- wobei der Ladungsübertragungskanal durch Überlappung der möglichen elektrostatischen Wirkung der Gatter mit der Leitungsschicht ausgebildet ist und
- und mit einem Taktgeber
- mit einer Taktfrequenz von über 100 MHz, bevorzugt von über 150 MHz, über 200 MHz oder über 250 MHz und besonders bevorzugt bis 300 MHz oder 400 MHz
- welcher die Gatter mit Potentialänderungen in Taktfrequenz beaufschlagt
- zum Transport von Ladungsträgern in der Taktfrequenz von benachbarten Bereichen der Überlappung von benachbarten Gattern mit der Leitungsschicht zu benachbarten Bereichen der Überlappung von benachbarten Gattern mit der Leitungsschicht wobei
- der Ladungsübertragungskanal einen Mündungsbereich aufweist
- welcher in Flussrichtung an einer seitlichen Aussengrenze des Ladungsübertragungskanals angeordnet ist und
- welcher sich mindestens teilweise über die Bereiche von genau zwei benachbarten Gates des Ladungsübertragungskanals erstreckt
- um dem Ladungsübertragungskanal von einem an den Mündungsbereich angrenzenden Bereich ausserhalb des Ladungsübertragungskanals, insbesondere von einem zweiten Ladungsträgerkanal, Ladungsträger zuzuführen und
- um den Rücklauf oder den Flusswiderstand oder den Verlust der Ladungsträger in Flussrichtung des Ladungsübertragungskanals oder des dem Ladungsübertragungskanals Ladungsträger zuführenden Bereichs, bevorzugt eines zweiten Ladungsübertragungskanals, zu reduzieren, wobei
- die Länge des Mündungsbereichs entlang des Leitungskanals
- kleiner ist als die Länge des Bereichs der zugeordneten zwei benachbarten Gatter entlang des Ladungsübertragungskanals und
- 45-75% oder 55-65% oder 60% der Länge des Bereichs der zugeordneten zwei benachbarten Gatter entlang des Ladungsübertragungskanals entspricht, wobei
- der Mündungsbereich
- mit seiner Länge entlang des Leitungsübertragungskanals
- über eine grössere Länge an den Bereich des entgegen der Flussrichtung liegenden zugeordneten Gatters versetzt angrenzt als an den Bereich des in Flussrichtung liegenden zugeordneten Gatters, wobei die Gatter mit Abständen elektrisch getrennt angeordnet sind, und
- bevorzugt mehr als 50%, mehr als 60%, zwischen 60% und 75%, oder zu 2/3 an den Bereich des entgegen der Flussrichtung liegenden zugeordneten Gatters angrenzt.

2. Ladungsübertragungsvorrichtung nach Anspruch 1, wobei
- der Mündungsbereich
- eine Ausbuchtung aufweist
- in welcher der Querschnitt zur Flussrichtung zuerst zunimmt, bevorzugt um mehr als 20%, 40%, 80% oder 100%, und dann wieder abnimmt, bevorzugt um mehr als 20%, 40%, oder 80%,
- welche sich in ihrer Länge in Flussrichtung mindestens oder genau über den Mündungsbereich erstreckt,
- wobei die Länge der Ausbuchtung in Flussrichtung kleiner ist als die Breite der Zunahme des Querschnitts, bevorzugt kleiner 50%, kleiner 25%, oder kleiner 12%,
- wobei die Ausbuchtung bevorzugt rechteckig ist.

3. Ladungsübertragungsvorrichtung nach einem der vorhergehenden Ansprüche, wobei
- der Ladungsübertragungskanal einen Bereich einer Verengung aufweist
- in welchem der Querschnitt in Flussrichtung abnimmt und
- welcher entgegen der Flussrichtung vor der Mündungsstelle und
- mindestens teilweise im Bereich des einen entgegen der Flussrichtung liegenden zugeordneten Gatters angeordnet ist und
- bevorzugt abgeschrägt und/oder trichterförmig ausgeführt ist
- um den Rücklauf oder den Flusswiderstand oder den Verlust der Ladungsträger in Flussrichtung zu reduzieren.

4. Ladungsübertragungsvorrichtung nach einem der vorhergehenden Ansprüche, wobei
- das Halbleitersubstrat p+ dotiert ist und/oder
- die Leitungsschicht schwach n- dotiert ist und/oder
- die Gatter aus Metall gebildet sind und/oder
- zwischen den Gattern und der Leitungsschicht eine nichtleitende Schicht angeordnet ist.

## Claims

1. Charge transfer device
- having a charge transfer channel in a semiconductor substrate
- having a doped conduction layer
- for movably accepting the charge carriers,
- having a sequence of at least two electrically isolated gates
- which adjacently succeed one another
- for transferring the charge carriers in the conduction layer
- in a flow direction,
- wherein the charge transfer channel is formed by overlap of the possible electrostatic effect of the gates with the conduction layer, and
- having a clock generator
- having a clock frequency of more than 100 MHz, preferably of more than 150 MHz, more than 200 MHz or more than 250 MHz and particularly preferably up to 300 MHz or 400 MHz,
- which applies changes in potential at the clock frequency to the gates,
- for transporting charge carriers at the clock frequency from adjacent regions of the overlap between adjacent gates and the conduction layer to adjacent regions of the overlap between adjacent gates and the conduction layer,
wherein
- the charge transfer channel has an influx region
- which, in the flow direction, is arranged at a lateral outer boundary of the charge transfer channel and
- which at least partly extends over the regions of exactly two adjacent gates of the charge transfer channel
- in order to supply charge carriers to the charge transfer channel from a region outside the charge transfer channel that adjoins the influx region, in particular from a second charge transfer channel, and
- in order to reduce the spillback or the flow resistance or the loss of the charge carriers in the flow direction of the charge transfer channel or of the region supplying charge carriers to the charge transfer channel, preferably of a second charge transfer channel,
wherein
- the length of the influx region along the conduction channel
- is less than the length of the region of the assigned two adjacent gates along the charge transfer channel and
- corresponds to 45-75% or 55-65% or 60% of the length of the region of the assigned two adjacent gates along the charge transfer channel, wherein
- the influx region
- with its length along the conduction transfer channel
- adjoins in an offset manner the region of the assigned gate situated counter to the flow direction over a greater length than the region of the assigned gate situated in the flow direction, wherein the gates are arranged with spacings in an electrically isolated manner, and
- preferably adjoins the region of the assigned gate situated counter to the flow direction to an extent of more than 50%, more than 60%, between 60% and 75%, or 2/3.

2. Charge transfer device according to Claim 1, wherein
- the influx region
- has a protuberance
- in which the cross section with respect to the flow direction first increases, preferably by more than 20%, 40%, 80% or 100%, and then decreases again, preferably by more than 20%, 40%, or 80%,
- which extends in terms of its length in the flow direction at least or exactly over the influx region,
- wherein the length of the protuberance in the flow direction is less than the width of the increase in the cross section, preferably less than 50%, less than 25%, or less than 12%,
- wherein the protuberance is preferably rectangular.

3. Charge transfer device according to either one of the preceding claims,
wherein
- the charge transfer channel has a region of a constriction
- in which the cross section decreases in the flow direction and
- which is arranged counter to the flow direction upstream of the influx location and
- at least partly in the region of the one assigned gate situated counter to the flow direction and
- is embodied preferably as bevelled and/or funnel-shaped
- in order to reduce the spillback or the flow resistance or the loss of the charge carriers in the flow direction.

4. Charge transfer device according to any one of the preceding claims,
wherein
- the semiconductor substrate is p+ doped and/or
- the conduction layer is weakly n- doped and/or
- the gates are formed from metal and/or
- a nonconducting layer is arranged between the gates and the conduction layer.

## Revendications

1. Dispositif de transfert de charge, comprenant
- un canal de transfert de charge dans un substrat semi-conducteur,
- une couche conductrice dopée
- pour recevoir les porteurs de charge de manière mobile,
- une série d'au moins deux grilles électriquement isolées
- qui se suivent en étant voisines
- pour décaler les porteurs de charge dans la couche conductrice
- dans une direction de flux,
- dans lequel le canal de transfert de charge est réalisé par le chevauchement de l'effet électrostatique possible des grilles avec la couche conductrice, et
- un générateur d'horloge
- ayant une fréquence d'horloge de plus de 100 Mhz, de préférence de plus de 150 Mhz, de plus de 200 Mhz ou de plus de 250 Mhz, et de manière particulièrement préférée jusqu'à 300 Mhz ou 400 MHz,
- qui soumet les grilles à des changements de potentiel à la fréquence d'horloge
- pour transporter des porteurs de charge à la fréquence d'horloge à partir de zones voisines du chevauchement de grilles voisines avec la couche conductrice jusqu'à des zones voisines du chevauchement de grilles voisines avec la couche conductrice,
dans lequel
- le canal de transfert de charge présente une zone d'embouchure
- qui est disposée dans la direction de flux à une limite extérieure latérale du canal de transfert de charge, et
- qui s'étend au moins en partie sur les zones d'exactement deux grilles voisines du canal de transmission de charge
- afin d'acheminer des porteurs de charge au canal de transfert de charge à partir d'une zone adjacente à la zone d'embouchure à l'extérieur du canal de transfert de charge, en particulier à partir d'un deuxième canal de transfert de charge, et
- pour réduire le retour ou la résistance au flux ou la perte des porteurs de charge dans la direction de flux du canal de transfert de charge ou de la zone acheminant des porteurs de charge au canal de transfert de charge, de préférence d'un deuxième canal de transfert de charge, dans lequel
- la longueur de la zone d'embouchure le long du canal de conduction
- est inférieure à la longueur de la zone des deux grilles voisines associées le long du canal de transfert de charge, et
- de 45 à 75 % ou de 55 à 65 % ou 60 % correspondent à la longueur de la zone des deux grilles voisines associées le long du canal de transfert de charge, dans lequel
- la zone d'embouchure est adjacente de manière décalée
- par sa longueur le long du canal de transfert de conduction
- sur une plus grande longueur à la zone de la grille associée située à l'opposé de la direction de flux qu'à la zone de la grille associée située dans la direction de flux, dans lequel les grilles sont disposées de manière électriquement isolée à intervalles, et
- est adjacente de préférence à plus de 50 %, plus de 60 %, entre 60 % et 75 % ou à 2/3 à la zone de la grille associée située à l'opposé de la direction de flux.

2. Dispositif de transfert de charge selon la revendication 1,
dans lequel
- la zone d'embouchure comprenant
- une échancrure
- dans laquelle la section transversale par rapport à la direction de flux augmente d'abord, de préférence de plus de 20 %, 40 %, 80 % ou 100 %, et diminue ensuite à nouveau, de préférence de plus de 20 %, 40 % ou 80 %,
- qui s'étend dans sa longueur dans la direction de flux au moins ou exactement sur la zone d'embouchure,
- dans lequel la longueur de l'échancrure dans la direction de flux est inférieure à la largeur de l'augmentation de la section transversale, de préférence inférieure à 50 %, inférieure à 25 % ou inférieure à 12 %,
- dans lequel l'échancrure est de préférence rectangulaire.

3. Dispositif de transfert de charge selon l'une quelconque des revendications précédentes,
dans lequel
- le canal de transfert de charge présente une zone d'un rétrécissement
- dans laquelle la section transversale diminue dans la direction de flux, et
- qui est disposée à l'opposé de la direction de flux en amont du point d'embouchure, et
- au moins partiellement dans la zone de ladite une grille associée située à l'opposé de la direction de flux, et
- est réalisée de préférence de manière chanfreinée et/ou en forme d'entonnoir
- afin de réduire le retour ou la résistance au flux ou la perte des porteurs de charge dans la direction de flux.

4. Dispositif de transfert de charge selon l'une quelconque des revendications précédentes,
dans lequel
- le substrat semi-conducteur est dopé p+, et/ou
- la couche conductrice est faiblement dopée n-, et/ou
- les grilles sont formées en métal, et/ou
- une couche non conductrice est disposée entre les grilles et la couche conductrice.
